# EUROPEAN PATENT SPECIFICATION

(11) **EP 3 929 699 B1**
(45) Date of publication and mention of the grant of the patent: **04.03.2026**
(21) Application number: 21180084.2
(22) Date of filing: 17.06.2021
(51) Int. Cl.: G06F 1/16, H04M 1/02, H10K 59/80

(54) **ELECTRONIC DEVICE**
ELEKTRONISCHE VORRICHTUNG
DISPOSITIF ÉLECTRONIQUE

(30) Priority: 24.06.2020 KR 20200077168
(43) Date of publication of application: 29.12.2021
(73) Proprietor: Samsung Display Co., Ltd., Gyeonggi-do 17113 (KR)
(72) Inventor: Min, Myoungan, Seonbuk-gu, Cheonan-si, Chungcheongnam-do (KR)
(74) Representative: Dr. Weitzel & Partner

(56) References cited:
- EP-A1- 3 780 566
- EP-A2- 2 448 243
- WO-A1-2020/000187
- WO-A1-2020/017153
- KR-A- 20190 140 384
- US-A1- 2019 302 504
- US-A1- 2020 186 688
- US-A1- 2021 141 266
- US-A1- 2021 200 020

## Description

### BACKGROUND

The disclosure herein relates to an electronic device, and more specifically, to an electronic device with improved reliability.

An electronic device is activated in response to an electrical signal. The electronic device may include a display unit displaying an image or a detection unit detecting an external input. In the display unit, the organic light emitting display panel has low power consumption, high luminance, and high response speed.

On the other hand, the electronic device may include an electronic module that receives an external signal or provides an output signal to the outside. The electronic module is received in an outer case or the like together with the display panel to form an electronic device.

Further background art can be found in the following patent documents: WO 2020/000187 A1, KR 2019 0140384 A and US 2019/302504 A1.

### SUMMARY

The disclosure provides an electronic device with improved visibility. The invention is defined by independent claim 1. Further aspects of the invention are outlined in dependent claims 2 to 15.

An embodiment of the disclosure provides an electronic device including a display module including a display area and a transmission area having a higher light transmittance than the display area; a lower film disposed under the display module; a protective member disposed under the lower film, the protective member including a module hole overlapping the transmission area and penetrating the protective member; at least one cover pattern disposed between the lower film and the protective member; and an electronic module overlapping the module hole. The at least one cover pattern may have a closed line shape surrounding the module hole. The cover pattern may be a ring, especially a black ring.

In an embodiment, the lower film may include an upper surface adjacent to the display module and a lower surface opposite to the upper surface, and the at least one cover pattern may be disposed on the lower surface of the lower film.

In an embodiment, the at least one cover pattern may overlap the electronic module, the at least one cover pattern including a penetration opening part exposing the lower surface of the lower film, and a width of the penetration opening part in a direction may be smaller than a width of the module hole in the direction.

In an embodiment, the at least one cover pattern may overlap the electronic module, the at least one cover pattern including a penetration opening part exposing the lower surface of the lower film, and a width of the penetration opening part in a direction may be equal to a width of the module hole in the direction.

In an embodiment, the protective member may include an upper surface adjacent to the lower film and a lower surface facing the upper surface, and the at least one cover pattern may be disposed on the upper surface of the protective member.

In an embodiment, the at least one cover pattern may include a penetration opening part overlapping the electronic module, and an inner side of the at least one cover pattern defining the penetration opening part may be aligned with an inner side of the protective member defining the module hole.

In an embodiment, the at least one cover pattern may include a first pattern disposed on the upper surface of the protective member, and a second pattern disposed on an inner side of a protective member defining the module hole.

In an embodiment, the electronic device may further include an adhesive layer disposed between the lower film and the protective member to attach the lower film and the protective member. The adhesive layer may overlap at least a portion of the at least one cover pattern.

In an embodiment, the adhesive layer may overlap the electronic module, the adhesive layer including an adhesive opening part exposing a portion of a lower surface of the lower film.

In an embodiment, the at least one cover pattern may include a plurality of cover patterns. That is, the electronic device may include a plurality of cover patterns.

In an embodiment, the at least one cover pattern may be in any one shape of a circle, an oval, and a polygon. That is, the ring form of the at least one cover pattern may delimit respectively enclose an area with the form of a circle, an oval or a polygon.

In an embodiment, the lower film may be transparent.

In an embodiment, the protective member may include at least one of a light shielding layer, a heat dissipating layer, and a cushion layer.

In an embodiment, the electronic device may be folded with respect to a (virtual) folding axis extending in a direction.

In an embodiment, the display module may include a light emitting pixel including at least one transistor, and a light emitting element electrically connected to the at least one transistor; and a non-light emitting pixel not including at least one of the at least one of transistor and the light emitting element. The non-light emitting pixel may not be disposed in the display area, and the light emitting pixel and the non-light emitting pixel may be mixed and disposed in the transmission area.

### BRIEF DESCRIPTION OF THE DRAWINGS

The accompanying drawings are included to provide a further understanding of the disclosure and are incorporated in and constitute a part of this specification. The drawings illustrate some embodiments of the disclosure and, together with the description, serve to explain principles of the disclosure. In the drawings:
FIG. 1A is a schematic perspective view of an electronic device in an unfolded state according to an embodiment;
FIG. 1B is a schematic perspective view of an electronic device in a folded state according to an embodiment;
FIG. 1C is a schematic plan view of an electronic device in a folded state according to an embodiment;
FIG. 1D is a schematic perspective view of an electronic device in a folded state according to an embodiment;
FIG. 2 is a schematic exploded perspective view of an electronic device according to an embodiment;
FIG. 3 is a block diagram of the electronic device shown in FIG. 1A;
FIG. 4A is a schematic plan view of a display panel according to an embodiment;
FIG. 4B is a schematic equivalent circuit diagram of a pixel according to an embodiment;
FIG. 5 is a schematic cross-sectional view of an electronic device according to an embodiment;
FIG. 6 is a schematic cross-sectional view of an electronic device according to an embodiment;
FIG. 7 is a schematic cross-sectional view of an electronic device according to an embodiment;
FIG. 8 is a schematic cross-sectional view of an electronic device according to an embodiment;
FIG. 9 is a schematic cross-sectional view of an electronic device according to an embodiment;
FIG. 10 is a schematic cross-sectional view of an electronic device according to an embodiment;
FIG. 11 is a schematic plan view of a cover pattern and a lower film according to an embodiment;
FIG. 12 is a schematic plan view of a cover pattern and a lower film according to an embodiment;
FIG. 13 is a schematic plan view of a cover pattern and a lower film according to an embodiment;
FIG. 14 is a schematic plan view of a display area according to an embodiment; and
FIG. 15 is a schematic plan view of a transmission area according to an embodiment.

### DETAILED DESCRIPTION OF THE EMBODIMENTS

In this specification, when it is mentioned that a component (or, an area, a layer, a part, etc.) is referred to as being "on," "connected to," or "combined to" another component, this means that the component may be directly on, connected to, or combined to the other component or a third component therebetween may be present.

Like reference numerals refer to like elements. Additionally, in the drawings, the thicknesses, proportions, and dimensions of components may be exaggerated for effective description.

The term "and/or" includes all of one or more combinations defined by related components. For example, "A and/or B" may be understood to mean "A, B, or A and B."

In the specification and the claims, the phrase "at least one of" is intended to include the meaning of "at least one selected from the group of" for the purpose of its meaning and interpretation. For example, "at least one of A and B" may be understood to mean "A, B, or A and B."

It will be understood that the terms "first," "second," and the like are used herein to describe various components but these components should not be limited by these terms. The above terms are used only to distinguish one component from another. For example, a first component may be referred to as a second component and vice versa without departing from the scope of the disclosure. The terms of a singular form may include plural forms unless otherwise specified.

Terms such as "below," "the lower side," "on," and "the upper side" are used to describe a structural relationship of configurations shown in the drawing. The terms are described as a relative concept based on a direction shown in the drawing.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly defined herein.

In various embodiments of the disclosure, the term "include," "comprise," "including," or "comprising," specifies a property, a region, a fixed number, a step, a process, an element and/or a component but does not exclude other properties, regions, fixed numbers, steps, processes, elements and/or components. Hereinafter, another embodiment of the disclosure will be described with reference to the drawings.

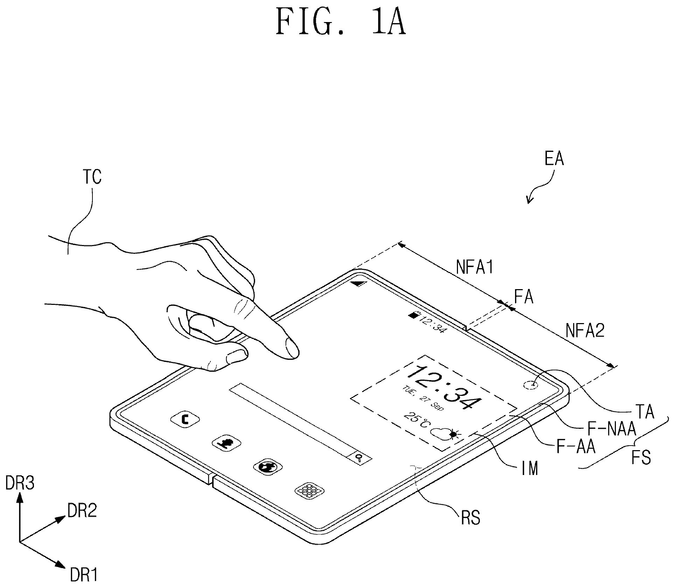

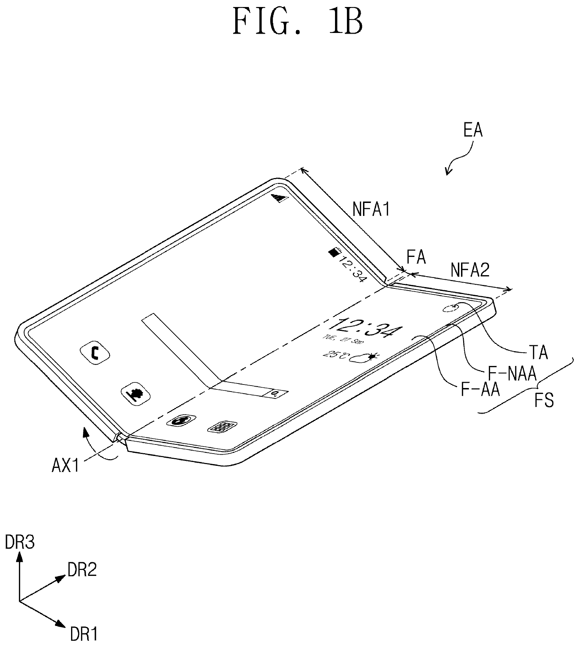

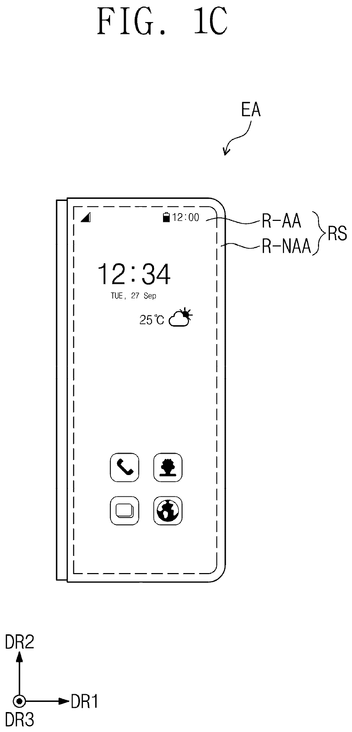

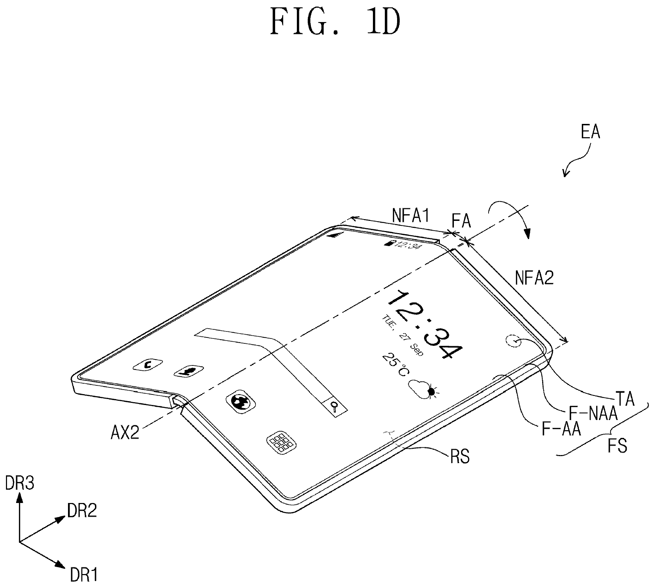

FIG. 1A is a schematic perspective view of an electronic device in an unfolded state according to an embodiment. FIG. 1B is a schematic perspective view of an electronic device in a folded state according to an embodiment. FIG. 1C is a schematic plan view of an electronic device in a folded state according to an embodiment. FIG. 1D is a schematic perspective view of an electronic device in a folded state according to an embodiment.

Referring to FIG. 1A, an electronic device EA may be a device that is activated in response to an electrical signal. The electronic device EA may include various embodiments. For example, the electronic device EA may include a tablet, a laptop computer, a personal computer, a smart television, and the like. In this embodiment, the electronic device EA is exemplarily shown as a smart phone.

The electronic device EA may display an image IM toward a third direction DR3 on a first display surface FS parallel to each of a first direction DR1 and a second direction DR2. The first display surface FS on which the image IM is displayed may correspond to a front surface of the electronic device EA. The Image IM may include still images and/or dynamic images. In FIG. 1A, a clock window is shown as an example of the image IM.

In this embodiment, the upper surface (or front surface) and the lower surface (or rear surface) of each member is defined based on the direction in which the image IM is displayed. The upper and lower surfaces may be opposite to each other in the third direction DR3, and normal directions of the upper and lower surfaces may be substantially parallel to the third direction DR3.

The separation distance between the upper and lower surfaces in the third direction DR3 may correspond to the thickness/height in the third direction DR3 of the electronic device EA. The first to third directions DR1, DR2, and DR3 are relative and may be converted to other directions.

The electronic device EA may detect an external input TC applied from the outside. The external input TC may include various types of inputs provided outside the electronic device EA. For example, the external input TC may include an external input TC (e.g., hovering) applied in close proximity or adjacent to the electronic device EA at a predetermined distance as well as a contact by a portion of a user's body, such as a user's hand. Further, the external input TC may include various forms such as force, pressure, and light, and is not limited to any one embodiment. FIG. 1A shows an external input TC by a user's hand as an example.

The electronic device EA according to the embodiment may include a first display surface FS and a second display surface RS. The first display surface FS may include a first active area F-AA and a first peripheral area F-NAA. The second display surface RS may be defined as a surface facing at least a portion of the first display surface FS. The electronic device EA may include a transmission area TA surrounded by the first active area F-AA.

The first active area F-AA may be an area activated according to an electrical signal. The first active area F-AA corresponds to an area in which the image IM is displayed and/or various types of external inputs TC may be detected. The first peripheral area F-NAA is adjacent to the first active area F-AA. The first peripheral area F-NAA may surround the first active area F-AA. Accordingly, the shape of the first active area F-AA may be substantially defined by the first peripheral area F-NAA.

However, this is illustrated by way of example, and the first peripheral area F-NAA may be disposed adjacent to a side of the first active area F-AA or may be omitted. The electronic device may have various embodiments and is not limited to any one embodiment.

The electronic device EA according to an embodiment may include at least one folding area FA and non-folding areas NFA1 and NFA2 extending from the folding area FA.

Referring to FIG. 1B, the electronic device EA according to an embodiment includes a virtual first folding axis AX1 extending in the second direction DR2. The first folding axis AX1 may extend in the second direction DR2 on the first display surface FS. In this embodiment, the non-folding areas NFA1 and NFA2 may extend from the folding area FA with the folding area FA interposed therebetween. For example, the first non-folding area NFA1 may extend from a side of the folding area FA in the first direction DR1, and the second non-folding area NFA2 may extend from another side of the folding area FA in the first direction DR1.

The electronic device EA is folded with respect to the first folding axis AX1 such that it may be transformed into an in-folded state in which the first non-folding area NFA1 of the first display surface FS and the second non-folding area NFA2 of the first display surface FS face each other.

Referring to FIG. 1C, in the electronic device EA according to an embodiment, the second display surface RS may be visually recognized by the user in the in-folded state. In this case, the second display surface RS may include a second active area R-AA displaying an image. The second active area R-AA may include an area activated according to an electrical signal. The second active area R-AA may include an area in which an image is displayed and various types of external inputs TC (see FIG. 1A) may be detected.

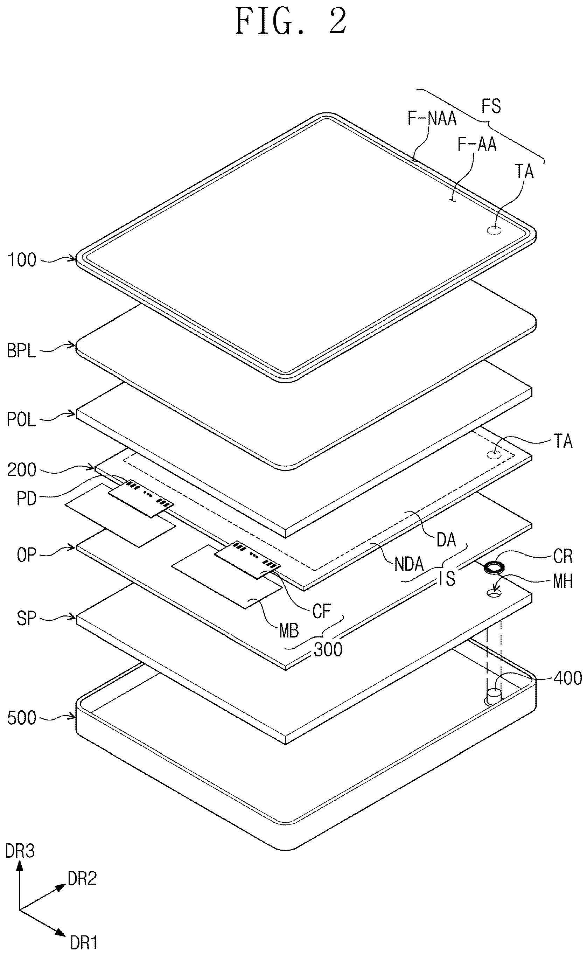

The second peripheral area R-NAA is adjacent to the second active area R-AA. The second peripheral area R-NAA may surround the second active area R-AA. Although not shown in the drawing, the second display surface RS may further include an area in which an electronic module 400 (see FIG. 2) is disposed but is not limited to any one embodiment.

Referring to FIG. 1D, an electronic device EA according to an embodiment includes a virtual second folding axis AX2 extending in the second direction DR2. The second folding axis AX2 may extend in the second direction DR2 on the second display surface RS.

The electronic device EA is folded with respect to the second folding axis AX2 such that it may be transformed into an out-folded state in which the first non-folding area NFA1 of the second display surface RS and the second non-folding area NFA2 of the second display surface RS face each other.

The electronic device EA is not limited thereto and may be folded with respect to multiple folding axes so that a portion of the first display surface FS and a portion of the second display surface RS face each other, and the number of folding axes and the number of non-folding areas corresponding thereto are not limited to any one embodiment.

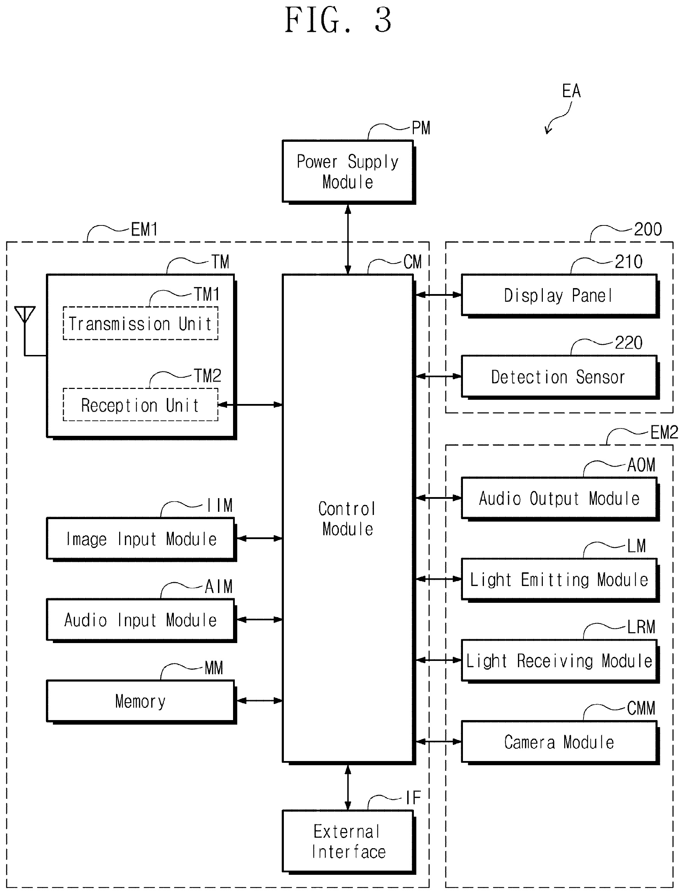

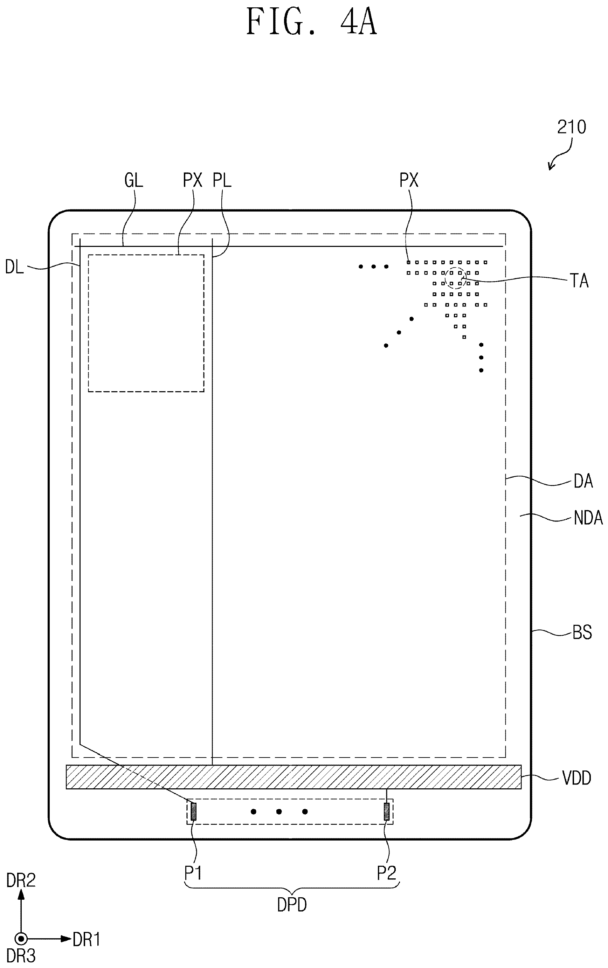

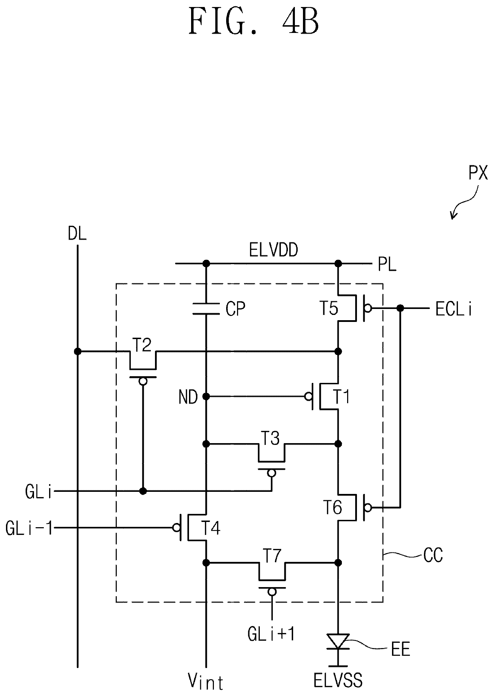

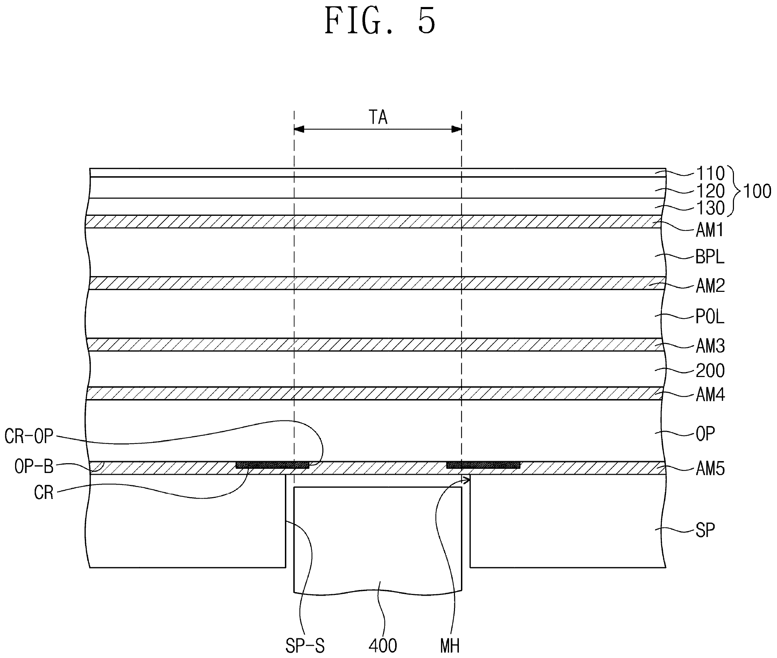

FIG. 2 is a schematic exploded perspective view of an electronic device according to an embodiment. FIG. 3 is a schematic block diagram of the electronic device shown in FIG. 1A. FIG. 4A is a schematic plan view of a display panel according to an embodiment. FIG. 4B is a schematic equivalent circuit diagram of a pixel according to an embodiment. FIG. 5 is a schematic cross-sectional view of an electronic device according to an embodiment.

Referring to FIG. 2, an electronic device EA according to an embodiment may include a window 100, a display module 200, a circuit board 300, an electronic module 400, and an outer case 500. As the electronic device EA has a folding characteristic, the electronic device EA may include a shock absorbing layer BPL, an optical member POL, a lower film OP, a cover pattern CR, and a code member SP.

The window 100 is disposed on the display module 200. The window 100 provides display surfaces FS and RS (see FIG. 1A) of the electronic device EA and protects the display module 200. The window 100 may include a material having high light transmittance. For example, the window 100 may include at least one of a glass substrate, a sapphire substrate, and a plastic film. Although not shown in the drawing, the window 100 may also be disposed on a portion of the outer case 500. An area of the outer case 500 in which the window 100 is disposed may correspond to the second display surface RS. For the sake of explanation, FIG. 2 shows an outer case 500 having an integral shape.

The window 100 may have a multi-layer or single-layer structure. For example, the window 100 may have a laminated structure of plastic films attached or bonded with an adhesive or may have a laminated structure of a glass substrate and a plastic film bonded with an adhesive.

An area of the window 100 through which light generated from the display module 200 is transmitted may be defined as a first active area F-AA of the first display surface FS, and the bezel area of the window 100 may be defined as a first peripheral area F-NAA. Another area of the window 100 through which light generated from the display module 200 is transmitted may be defined as a second active area R-AA of the second display surface RS, and the bezel area of the window 100 may be defined as a second peripheral area R-NAA.

The display module 200 may function as an output device. For example, the display module 200 may display an image IM in the active areas F-AA and R-AA, and a user may obtain information through the image IM. The display module 200 may function as an input device that detects an external input TC applied to the active areas F-AA and R-AA.

The display module 200 includes an upper surface IS and a rear surface opposite to the upper surface IS. The upper surface IS may include a display area DA for displaying an image IM and detecting an external input TC, and a non-display area NDA adjacent to the display area. The non-display area NDA may be an area in which a driving circuit for driving the pixel PX and wires electrically connected thereto and wires electrically connected to detection electrodes detecting an external input TC are disposed. The display area DA may overlap at least part of the first active area F-AA, and the non-display area NDA may overlap at least part of the peripheral area F-NAA. In the disclosure, the transmission area TA may overlap the electronic module 400 and may have a relatively high light transmittance compared to the display area DA.

The circuit board 300 may be electrically connected to the display module 200. The circuit board 300 may include a flexible substrate CF and a main board MB. The flexible substrate CF may include an insulating film and conductive wires mounted on the insulating film. The conductive wires are electrically connected to pads PD to electrically connect the circuit board 300 and the display module 200.

In this embodiment, the flexible substrate CF may be assembled in a bent state. Accordingly, the main board MB is disposed on the lower surface of the display module 200 and may be stably accommodated in the space provided by the outer case 500. In an embodiment, the flexible substrate CF may be omitted, and in this case, the main board MB may be directly connected to the display module 200.

The main board MB may include signal lines and electronic elements (not shown). The electronic elements may be electrically connected to the signal lines and the display module 200. The electronic elements generate various electrical signals, for example, a signal for generating the image IM or a signal for detecting an external input TC, or process detected signals. Multiple main boards MB may be provided corresponding to each of electrical signals for generation and processing but are not limited to any one embodiment.

The electronic module 400 may be accommodated in the outer case 500. The electronic module 400 according to the disclosure is disposed to overlap the module hole MH through which the protective member SP disposed on the electronic module 400 penetrates and may receive an input transmitted from the outside through a transmission area TA overlapping the module hole MH or may provide an output to a user through the transmission area TA.

The transmission area TA according to the disclosure may be variously modified within the first active area F-AA according to an area in which the electronic module 400 is disposed. The position of the module hole MH defined in the protective member SP may be variously modified according to the area in which the electronic module 400 is disposed.

According to the disclosure, as the electronic module 400 is disposed to overlap the active areas F-AA and R-AA (see FIGS. 1A and 1C) of the window 100, a separate space for arranging the electronic module 400 in the peripheral areas F-NAA and R-NAA may be omitted. Accordingly, it is possible to prevent an increase in the peripheral areas F-NAA and R-NAA included in the electronic device EA. Accordingly, it is possible to provide the electronic device EA with improved aesthetics.

The outer case 500 may be combined with the window 100. The outer case 500 provides a rear surface of the electronic device EA. The outer case 500 is combined with the window 100 to provide an inner space. The display module 200, the circuit board 300, and the electronic module 400 may be accommodated in the inner space.

The outer case 500 may include a material having a relatively high stiffness. For example, the outer case 500 may include frames and/or plates made of or including glass, plastic, or metal. The outer case 500 may stably protect the structures of the electronic device EA accommodated in the inner space from external impacts. Although not shown in the drawing, the window 100 providing a second display surface RS may be further included on a surface of the outer case 500.

The shock absorbing layer BPL may be disposed between the window 100 and the display module 200. The shock absorbing layer BPL may protect the components of the display module 200 from stress applied during folding. The shock absorbing layer BPL may be selected from films having an elastic modulus of about 1 GPa or greater at the room temperature. The shock absorbing layer BPL may be a stretched film (or stretchable film) having an optical function. For example, the shock absorbing layer BPL may be an optical axis control film.

The optical member POL may be disposed between the display module 200 and the shock absorbing layer BPL. The optical member POL may reduce reflectance of external light of the display module 200 with respect to light incident on the display module 200. For example, the optical member POL may include at least one of an antireflection film, a polarizing film, a color filter, and a gray filter.

The lower film OP may be disposed between the display module 200 and the protective member SP. The lower film OP may form a neutral surface to minimize stress applied to the inside of the display module 200 during folding.

The lower film OP according to the disclosure may be provided with a transparent material. As the electronic module 400 is disposed under the lower film OP, in case that the lower film OP has a color, light transmitted through the lower film OP and provided to the electronic module 400 may be diffracted and/or interfered by the lower film OP. Accordingly, the performance of the electronic module 400 may be deteriorated.

As the lower film OP according to the disclosure may include a transparent material, in case that there is no hole through which the separate lower film OP is penetrated, light provided from outside or light provided from an electronic module may be transmitted and received without interference. Accordingly, it may be possible to provide the electronic module 400 with improved reliability.

The lower film OP may include a plastic film including one selected from the group consisting of polyethersulfone (PES), polyacrylate, polyetherimide (PEI), polyethylenenaphthalate (PEN), polyethyleneterephthalate (PET), polyphenylene sulfide (PPS), polyarylate, polyimide (PI), polycarbonate (PC), poly(arylene ethersulfone), and a combination thereof. The material constituting the lower film OP is not limited to plastic resins and may include a transparent organic/inorganic composite material.

The protective member SP may be disposed under the display module 200. In the embodiment, the protective member SP is disposed under the display module 200 to protect the display module 200 from external impact.

The protective member SP according to an embodiment may include layers. For example, the protective member SP includes a light shielding layer, a heat dissipating layer, a cushion layer, and adhesive layers.

The light shielding layer may prevent or reduce visibility of components disposed on the rear surface of the display module 200. Although not shown in the drawing, the light shielding layer may include a binder and pigment particles dispersed therein. Pigment particles may include carbon black or the like.

The display module 200 according to an embodiment includes a protective member SP including a light shielding layer, such that it may have an effect of improving light shielding property as well as improving impact resistance. It is possible to provide an electronic device EA with improved visibility and reliability for external impact or stress generated during use.

The heat dissipating layer may effectively dissipate heat generated from the display module 200. The heat dissipating layer may be a metal plate with good heat dissipation properties. For example, the heat dissipating layer may include at least one of stainless steel, graphite, copper (Cu), and aluminum (Al) but is not limited thereto. The heat dissipating layer not only improves heat dissipation properties, but also has electromagnetic shielding or electromagnetic absorption properties.

The cushion layer may be a synthetic resin foam. The cushion layer includes a matrix member and voids (or holes). The voids may be dispersed and defined in the matrix member. The cushion layer according to an embodiment may be disposed under the heat dissipating layer. The cushion layer may have elasticity and have a porous structure.

The cushion layer may include any one of a sponge, foam, or urethane resin. In case that the cushion layer includes a foam, the cushion layer includes a matrix member and voids. The voids may be dispersed and defined in the matrix member. The cushion layer may have elasticity and have a porous structure.

The matrix member may include a flexible material. For example, the matrix member includes synthetic resin. For example, the matrix member may include at least one of acrylonitrile butadiene styrene copolymer (ABS), polyurethane (PU), polyethylene (PE), ethylene vinyl acetate (EVA), and polyvinyl chloride (PVC).

The voids easily absorb the impact applied to the cushion layer. The voids may be defined in the cushion layer having a porous structure. The voids may improve the elasticity of the cushion layer by making it easy to deform the shape of the cushion layer, thereby improving the impact resistance of the electronic device EA. The cushion layer may include synthetic resins but is not limited to any one embodiment.

The electronic device EA according to the disclosure may include a cover pattern CR. The cover pattern CR may be disposed between the lower film OP and the protective member SP. The cover pattern CR may overlap the electronic module 400. The cover pattern CR may have a closed line shape surrounding the electronic module 400. In case that the electronic module 400 is a camera module CMM in an embodiment, the cover pattern CR may provide an angle of view of the camera module CMM that may prevent a defect in which the surface configuration of the camera module CMM is visually recognized to the outside. Thus, the cover pattern CR may have a black color. However, the color of the cover pattern CR is not limited thereto, and the cover pattern CR is not limited to any one including a material that blocks light.

Referring to FIG. 3, the electronic device EA may include a display module 200, a power supply module PM, a first electronic module EM1, and a second electronic module EM2. The display module 200, the power supply module PM, the first electronic module EM1, and the second electronic module EM2 may be electrically connected to each other.

The display module 200 may include a display panel 210 and a detection sensor 220. The display panel 210 may have a configuration for generating an image 1M. The image IM generated by the display panel 210 is visually recognized by the user from the outside through the first active area F-AA. The detection sensor 220 may have a configuration for sensing the external input TC (see FIG. 1A).

The first electronic module EM1 and the second electronic module EM2 may include various functional modules for operating the electronic device EA. The first electronic module EM1 may be directly mounted on a motherboard electrically connected to the display module 200 or may be mounted on a separate board and electrically connected to the motherboard through a connector (not shown) or the like.

The first electronic module EM1 may include a control module CM, a wireless communication module TM, an image input module 11M, an audio input module AIM, a memory MM, and an external interface IF. Some of the modules may not be mounted on the motherboard but may be electrically connected to the motherboard through a flexible circuit board.

The control module CM controls the overall operation of the electronic device EA. The control module CM may include a processor or microprocessor available in the art. For example, the control module CM activates or deactivates the display module 200. The control module CM may control other modules such as the image input module IIM and the audio input module AIM based on a touch signal received from the display module 200.

The wireless communication module TM may transmit/receive a wireless signal to/from another terminal for example using a Bluetooth and/or Wi-Fi technology. In an embodiment, the wireless communication module TM may transmit/receive a voice signal using a general communication line. The wireless communication module TM includes a transmission unit TM1 for modulating and transmitting a signal to be transmitted, and a reception unit TM2 for demodulating the received signal.

The image input module IIM processes the image signal and converts it into image data that may be displayed on the display module 200. The audio input module AIM receives an external audio signal by a microphone in a recording mode, a voice recognition mode, etc., and converts it into electrical voice data.

The external interface IF functions as an interface, e.g., to an external charger, a wired/wireless data port, a card socket (e.g., a memory card, a SIM/UIM card).

The second electronic module EM2 may include an audio output module AOM, a light emitting module LM, a light receiving module LRM, and a camera module CMM. The configurations may be directly mounted on the motherboard or mounted on a separate substrate, and electrically connected to the display module 200 or electrically connected to the first electronic module EM1 through a connector (not shown).

The audio output module AOM converts the audio data received from the wireless communication module TM or the audio data stored in the memory MM and outputs the converted audio data.

The light emitting module LM generates and outputs light. The light emitting module LM may output infrared rays. For example, the light emitting module LM may include an LED element. For example, the light receiving module LRM may detect infrared rays. The light receiving module LRM may be activated in case that an infrared ray of a predetermined level or higher is detected. The light receiving module LRM may include a sensor (e.g., CMOS sensor). After the infrared light generated by the light emitting module LM is outputted, the infrared light is reflected by an external object (e.g., a user finger or a face), and the reflected infrared light may be incident on the light receiving module LRM. The camera module CMM captures an image of the outside.

The electronic module 400 according to an embodiment may include at least one of the configurations of the first electronic module EM1 and the second electronic module EM2. For example, the electronic module 400 may include at least one of a camera, a speaker, a light detection sensor, and a thermal detection sensor.

The electronic module 400 may detect an external subject received through the transmission area TA or provide a sound signal such as voice to the outside through the transmission area TA. The electronic module 400 may have multiple configurations but is not limited to any one embodiment.

Although not shown in the drawing, the electronic device EA according to an embodiment may further include a transparent member disposed between the electronic module 400 and the display module 200. The transparent member may be an optically transparent film so that an external input transmitted through the transmission area TA may be transmitted to the electronic module 400 through the transparent member. The transparent member may be attached to the rear surface of the display module 200 or may be disposed between the display module 200 and the electronic module 400 without a separate adhesive layer. The electronic device EA according to an embodiment may have various structures and is not limited to any one embodiment.

According to the disclosure, the electronic module 400 may be assembled so as to overlap the transmission area TA included in the first active area F-AA (see FIG. 1A) on a plane or in a plan view. Accordingly, an increase in the first peripheral area F-NAA (see FIG. 1A) due to the accommodation of the electronic module 400 may be prevented, so that the aesthetic feeling of the electronic device EA may be improved.

Referring to FIG. 4A, a display panel 210 according to an embodiment includes a base substrate BS, pixels PX, signal lines GL, DL, and PL, and display pads DPD. The base substrate BS may include the display area AA and the non-display area NDA. The base substrate BS may include an insulating substrate. For example, the base substrate BS may include a glass substrate, a plastic substrate, or a combination thereof.

The signal lines GL, DL and PL are electrically connected to the pixels PX to transmit electrical signals to the pixels PX. FIG. 4A illustrates a scan line GL, a data line DL, and a power supply line PL among signal lines included in the display panel 210 by way of example. In an embodiment, the signal lines GL, DL, and PL may further include at least one of a power supply line, an initialization voltage line, and a light emission control line, but is not limited to any one embodiment.

In FIG. 4B, an equivalent circuit diagram of a pixel PX among pixels is enlarged and illustrated as an example. FIG. 4B illustrates a pixel PX electrically connected to the i-th scan line GLi and the i-th light emission control line ECLi.

The pixel PX may include a light emitting element EE and a pixel circuit CC. The pixel circuit CC may include transistors T1 to T7 and a capacitor CP. The transistors T1 to T7 may be formed through a low temperature polycrystalline silicon (LTPS) process or a low temperature polycrystalline oxide (LTPO) process.

The pixel circuit CC controls the amount of current flowing through the light emitting element EE in response to the data signal. The light emitting element EE may emit light at a predetermined luminance corresponding to the amount of current supplied from the pixel circuit CC. For this, the level of the first power supply ELVDD may be set higher than the level of the second power supply ELVSS. The light emitting element EE may include an organic light emitting element or a quantum dot light emitting element.

Each of the transistors T1 to T7 may include an input electrode (or a source electrode), an output electrode (or a drain electrode), and a control electrode (or a gate electrode). In the disclosure, for the sake of convenience, either the input electrode or the output electrode may be referred to as a first electrode and the other may be referred to as a second electrode.

The first electrode of the first transistor T1 is electrically connected to the first power supply ELVDD through the fifth transistor T5, and the second electrode of the first transistor T1 is electrically connected to the anode electrode of the light emitting element EE through the sixth transistor T6. The first transistor T1 may be referred to as a driving transistor in an embodiment.

The first transistor T1 controls the amount of current flowing through the light emitting element EE in response to the voltage applied to the control electrode of the first transistor T1.

The second transistor T2 is electrically connected between the data line DL and the first electrode of the first transistor T1. Then, the control electrode of the second transistor T2 is electrically connected to the i-th scan line GLi. The second transistor T2 is turned on in case that the i-th scan signal is provided to the i-th scan line GLi, thereby electrically connecting the data line DL and the first electrode of the first transistor T1.

The third transistor T3 is electrically connected between the second electrode of the first transistor T1 and the control electrode of the first transistor T1. The control electrode of the third transistor T3 is electrically connected to the i-th scan line GLi. The third transistor T3 is turned on in case that the i-th scan signal is provided to the i-th scan line GLi, thereby electrically connecting the second electrode of the first transistor T1 and the control electrode of the first transistor T1. Therefore, in case that the third transistor T3 is turned on, the first transistor T1 is electrically connected in a diode form or diode-connected.

The fourth transistor T4 is electrically connected between a node ND and an initialization power generation unit (not shown). The control electrode of the fourth transistor T4 is electrically connected to the i-1-th scan line GLi-1. The fourth transistor T4 is turned on in case that the i-1-th scan signal is provided to the i-1-th scan line GLi-1, thereby providing the initialization voltage Vint to the node ND.

The fifth transistor T5 is electrically connected between the power supply line PL and the first electrode of the first transistor T1. The control electrode of the fifth transistor T5 is electrically connected to the i-th light emission control line ECLi.

The sixth transistor T6 is electrically connected between the second electrode of the first transistor T1 and the anode electrode of the light emitting element EE. The control electrode of the sixth transistor T6 is electrically connected to the i-th light emission control line ECLi.

The seventh transistor T7 is electrically connected between the initialization power generation unit (not shown) and the anode electrode of the light emitting element EE. The control electrode of the seventh transistor T7 is electrically connected to the i+1-th scan line GLi+1. In such a way, the seventh transistor T7 is turned on in case that the i+1-th scan signal is provided to the i+1-th scan line GLi+1, thereby providing the initialization voltage Vint to the anode electrode of the light emitting element EE.

The seventh transistor T7 may improve the black display capability of the pixel PX. In case that the seventh transistor T7 is turned on, the parasitic capacitor (not shown) of the light emitting element EE is discharged. In case that the black luminance is selected, the light emitting element EE does not emit light due to the leakage current from the first transistor T1, and thus the black display capability may be improved.

Although the control electrode of the seventh transistor T7 is illustrated as being electrically connected to the i+1-th scan line GLi+1 in FIG. 4B, the disclosure is not limited thereto. In another embodiment, the control electrode of the seventh transistor T7 may be electrically connected to the i-th scan line GLi or the i-1-th scan line GLi-1.

The capacitor CP is disposed between the power supply line PL and the node ND. The capacitor CP stores a voltage corresponding to the data signal. In case that the fifth transistor T5 and the sixth transistor T6 are turned on according to the voltage stored in the capacitor CP, the amount of current flowing through the first transistor T1 may be determined.

The equivalent circuit of the pixel PX in the disclosure is not limited to the equivalent circuit shown in FIG. 4B. In another embodiment, the pixel PX may be implemented in various forms for causing the light emitting element EE to emit light. In FIG. 4B, a PMOS is shown as a reference, but the disclosure is not limited thereto. In another embodiment, the pixel circuit CC may include an NMOS. In another embodiment, the pixel circuit CC may be configured by a combination of an NMOS and a PMOS.

According to the disclosure, light emitting pixels may be disposed in the display area DA, and non-light emitting pixels and light emitting pixels may be disposed in the transmission area TA.

The light emitting pixel and the pixel PX described above may have substantially the same configuration. For example, the light emitting pixel may include a light emitting element EE and a pixel circuit CC.

The non-light emitting pixel may be defined by omitting any one of elements included in the light emitting element EE and the pixel circuit CC. For example, in relation to the non-light emitting pixel, one of the electrodes included in the light emitting element EE in the configuration of the pixel PX may be omitted, or any one of the transistors T1 to T7 may be omitted. Accordingly, the non-light emitting pixel may be defined as a configuration in which light is not substantially generated.

According to the disclosure, as a non-light emitting pixel is included in the transmission area TA of the display panel 210 overlapping the electronic module 400, transmittance of light incident to the transmission area TA or externally provided through the transmission area TA may be improved. Accordingly, it is possible to provide the electronic module 400 with improved reliability.

In FIG. 4A, the transmission area TA is shown to be provided on the upper right end but is not limited thereto and may vary in various ways according to the position of the electronic module 400 overlapping the display area DA. Although shown in a circular shape, it may have a bar shape extending in the first direction DR1 or may be provided in a rectangular shape but is not limited to any one embodiment.

Still referring to FIG. 4A, the power supply pattern VDD is disposed in the non-display area NDA. In this embodiment, the power supply pattern VDD is electrically connected to power supply lines PL. Accordingly, the display panel 210 may provide substantially the same first power supply signal to the pixels PX by including the power supply pattern VDD.

Display pads DPD may include a first pad P1 and a second pad P2. The first pads P1 may be electrically connected to the data lines DL, respectively. The second pad P2 may be electrically connected to the power supply pattern VDD and electrically connected to the power supply line PL. The display panel 210 may provide electrical signals to the pixels PX externally provided through the display pads DPD. The display pads DPD may further include pads for receiving electrical signals other than the first pad P1 and the second pad P2 and are not limited to any one embodiment.

In FIG. 5, for the sake of convenience, an area adjacent to the transmission area TA is enlarged and illustrated, and the outer case 500 and the circuit board 300 are omitted.

The window 100 may include a hard coating layer 110, a protective layer 120, and a base member 130.

The hard coating layer 110 may correspond to a layer disposed on the outermost surface of the electronic device EA. The hard coating layer 110 is a functional layer for improving use characteristics of the electronic device EA and may be coated on the protective layer 120. For example, the hard coating layer 110 may improve anti-fingerprint properties, anti-pollution properties, and anti-scratch properties.

The protective layer 120 may be disposed under the hard coating layer 310. The protective layer 120 may protect components disposed under the protective layer 120. The protective layer 120 may be additionally provided with a hard coating layer and an anti-fingerprint layer to improve properties such as chemical resistance and abrasion resistance. In an embodiment, the protective layer 120 may be omitted.

The base member 130 may be disposed under the protective layer 120. The base member 130 may include an optically transparent insulating material. For example, the base member 130 may include a glass substrate or a synthetic resin film.

In case that the base member 130 is a synthetic resin film, the base member 130 may include a polyimide (Pl) film or a polyethylene terephthalate (PET) film.

The base member 130 may have a multilayer structure or a single layer structure. For example, the base member 130 may include synthetic resin films bonded with an adhesive or may include a glass substrate and a synthetic resin film bonded with an adhesive.

The shock absorbing layer BPL may be disposed between the window 100 and the optical member POL. The shock absorbing layer BPL may be connected to the window 100 by the first adhesive layer AM1.

The optical member POL may be disposed between the shock absorbing layer BPL and the display module 200. The optical member POL may be connected to the shock absorbing layer BPL by the second adhesive layer AM2.

The display module 200 may be disposed between the optical member POL and the lower film OP. The display module 200 may be connected to the optical member POL by the third adhesive layer AM3.

The lower film OP may be disposed between the display module 200 and the protective member SP. The lower film OP may be connected to the display module 200 by the fourth adhesive layer AM4.

The protective member SP may be disposed under the lower film OP. The protective member SP may be connected to the lower film OP by the fifth adhesive layer AM5.

In the protective member SP according to the disclosure, a module hole MH into which the electronic module 400 overlaps may be defined. For example, electronic module 400 may be inserted into the module hole MH. The module hole MH may be defined by the side surface SP-S of the protective member SP exposed through the upper and lower surfaces of the protective member SP. A portion of the fifth adhesive layer AM5 may be exposed through the module hole MH.

In this embodiment, the cover pattern CR is disposed on the lower surface OP-B of the lower film OP. The cover pattern CR may be covered or overlapped by the fifth adhesive layer AM5. A penetration opening part CR-OP overlapping the electronic module 400 and exposing the lower surface OP-B may be defined in the cover pattern CR. The width of the penetration opening part CR-OP in a direction may be smaller than the width of the module hole MH in the direction.

The cover pattern CR according to the disclosure may be formed by printing a pigment or dye having a black color on the lower surface OP-B of the lower film OP or may be provided in the form of a tape to be attached to the lower surface OP-B of the lower film OP.

According to the disclosure, the cover pattern CR is disposed between the protective member SP where the module hole MH is defined and the lower film OP. Separate holes for inserting the electronic module 400 are not formed in the components disposed on the protective member SP. In particular, as a physical hole is not formed in the display module 200, damage applied to the display module 200 may be minimized. Thus, an electronic device EA with improved reliability may be provided.

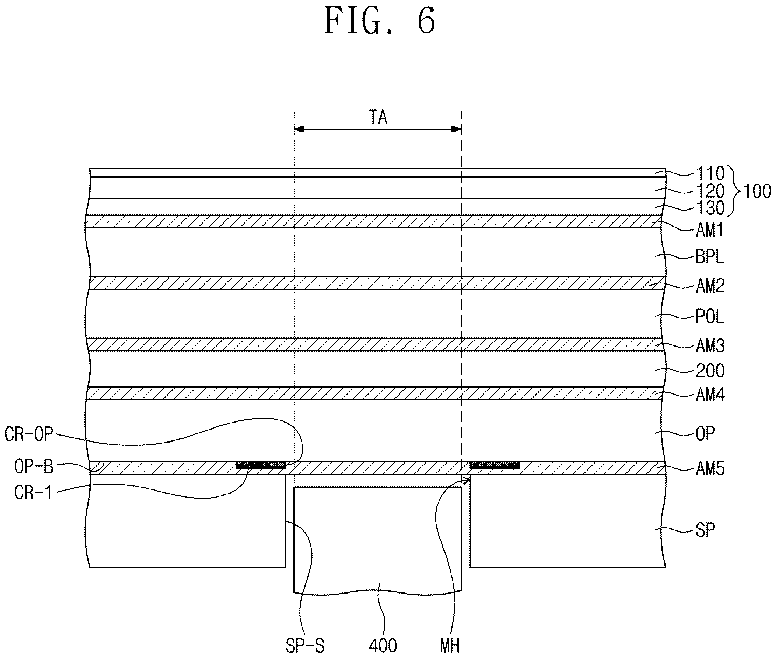

FIG. 6 is a schematic cross-sectional view of an electronic device according to an embodiment. The same/similar reference numerals are used for the same/similar components as that in FIG. 5, and repetitive descriptions may be omitted.

In this embodiment, the cover pattern CR-1 is disposed on the lower surface OP-B of the lower film OP. The cover pattern CR-1 may be overlapped by the fifth adhesive layer AM5. A penetration opening part CR-OP overlapping the electronic module 400 and exposing the lower surface OP-B may be defined in the cover pattern CR-1. The width of the penetration opening part CR-OP in a direction may be substantially identical to the width of the module hole MH in the direction.

Accordingly, the inner side surface of the lower film OP defining the penetration opening part CR-OP may be aligned with the inner side surface of the protective member SP defining the module hole MH.

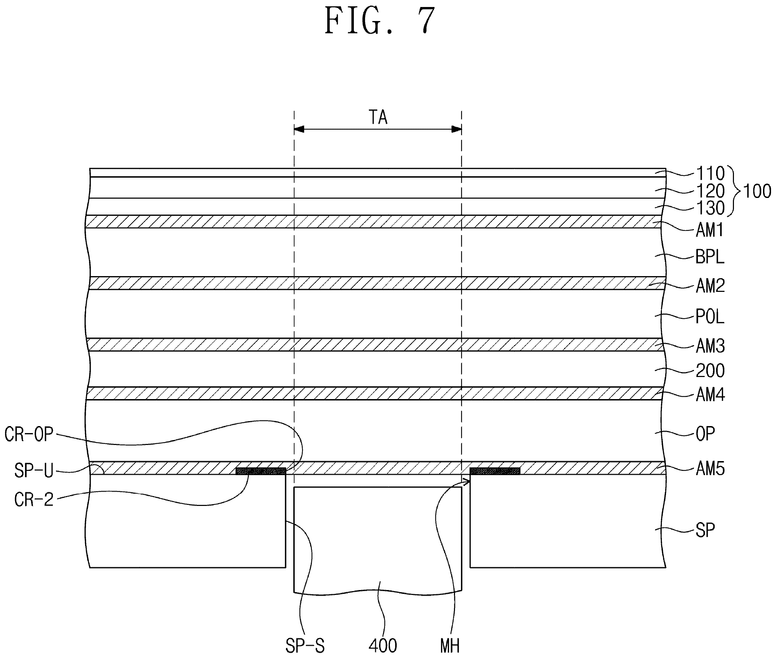

FIG. 7 is a schematic cross-sectional view of an electronic device according to an embodiment. The same/similar reference numerals are used for the same/similar components as that in FIG. 5, and repetitive descriptions may be omitted.

In this embodiment, the cover pattern CR-2 is disposed on the upper surface SP-U of the protective member SP. The cover pattern CR-2 may be overlapped by the fifth adhesive layer AM5. A penetration opening part CR-OP overlapping the electronic module 400 may be defined in the cover pattern CR-2. The width of the penetration opening part CR-OP in a direction may be substantially equal to the width of the module hole MH in the direction.

Accordingly, the inner side surface of the lower film OP defining the penetration opening part CR-OP may be aligned with the inner side surface of the protective member SP defining the module hole MH.

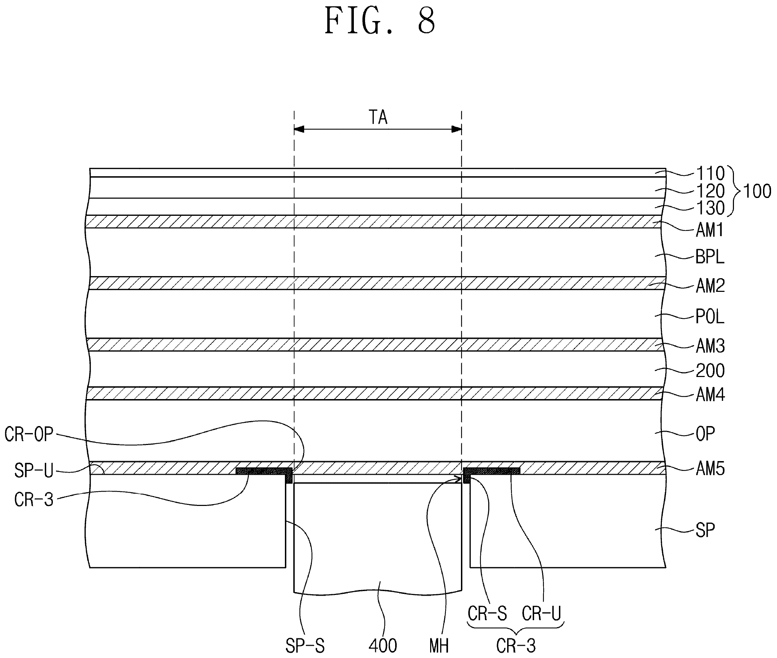

FIG. 8 is a schematic cross-sectional view of an electronic device according to an embodiment. The same/similar reference numerals are used for the same/similar components as that in FIG. 5, and repetitive descriptions may be omitted.

In this embodiment, the cover pattern CR-3 may include a first pattern CR-U and a second pattern CR-S. The first pattern CR-U may be disposed on the upper surface SP-U of the protective member SP, and the second pattern CR-S may be disposed on the side surface SP-S of the protective member SP.

The first pattern CR-U of the cover patterns CR-3 may be overlapped by the fifth adhesive layer AM5. A penetration opening part CR-OP overlapping the electronic module 400 may be defined in the cover pattern CR-3.

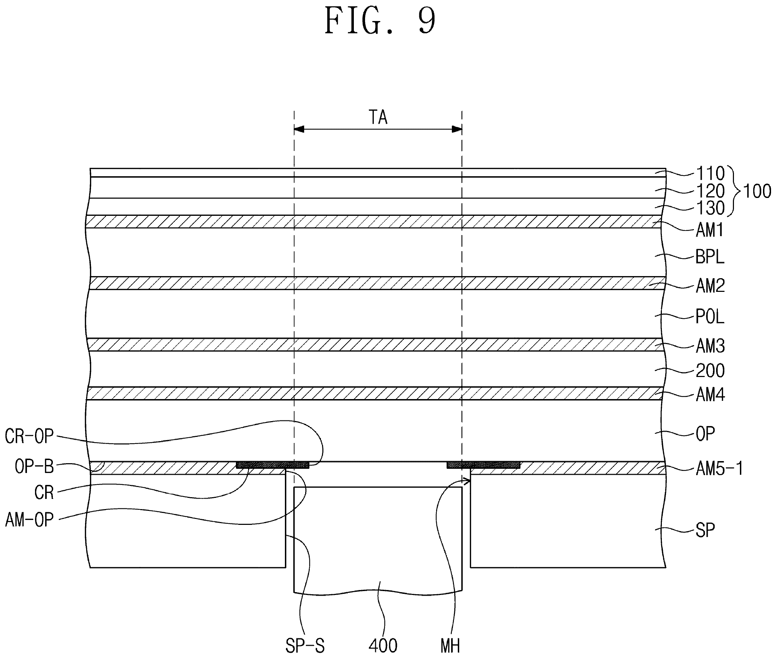

FIG. 9 is a schematic cross-sectional view of an electronic device according to an embodiment. The same/similar reference numerals are used for the same/similar components as that in FIG. 5, and repetitive descriptions may be omitted.

In this embodiment, the cover pattern CR is disposed on the lower surface OP-B of the lower film OP. At least a portion of the cover pattern CR may be overlapped by a fifth adhesive layer AM5-1. A penetration opening part CR-OP overlapping the electronic module 400 may be defined in the cover pattern CR.

In this embodiment, an adhesive opening part AM-OP overlapping the electronic module 400 and exposing a portion of the lower surface OP-B of the lower film OP may be defined in the fifth adhesive layer AM5-1.

The width of the penetration opening part CR-OP in a direction may be smaller than the width of the adhesive opening part AM-OP in the direction. Accordingly, the fifth adhesive layer AM5-1 may expose at least a portion of the cover member CR.

According to the embodiment, by removing the fifth adhesive layer AM5-1 in the area overlapping the electronic module 400, interference of light provided to the electronic module 400 may be reduced. Thus, an electronic device EA with improved reliability may be provided.

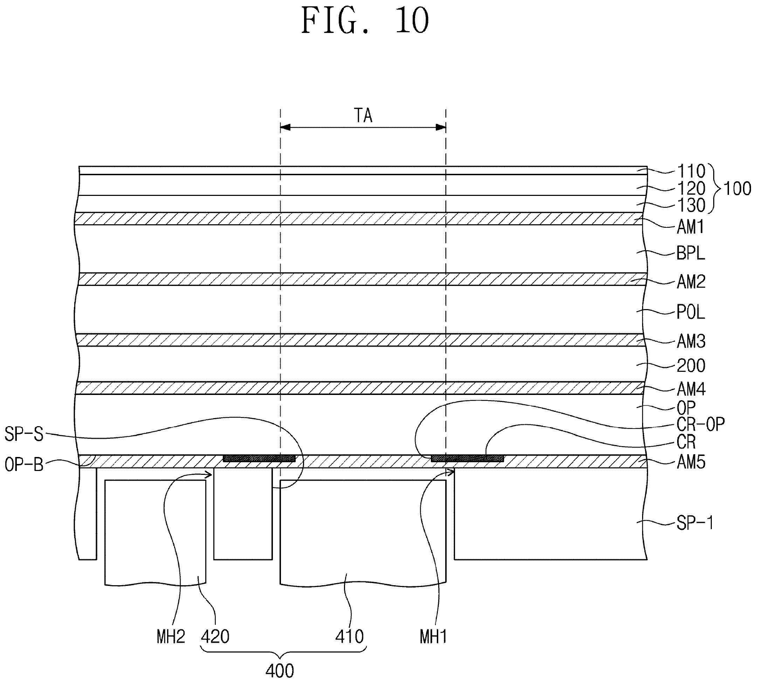

FIG. 10 is a schematic cross-sectional view of an electronic device according to an embodiment. The same/similar reference numerals are used for the same/similar components in FIG. 5, and repetitive descriptions may be omitted.

In this embodiment, the cover pattern CR is disposed on the lower surface OP-B of the lower film OP. The cover pattern CR may be overlapped by the fifth adhesive layer AM5. A penetration opening part CR-OP overlapping the electronic module 400 may be defined in the cover pattern CR.

In this embodiment, the electronic module 400 may include a first module 410 including a camera module CMM (see FIG. 3) and a second module 420 that is a proximity illuminance sensor.

The second module 420 may include a light emitting module LM and a light receiving module LRM. The light emitting module LM and the light receiving module LRM may be mounted on a single substrate. The light emitting module LM may generate and output light. For example, the light emitting module LM may output infrared light, and the light emitting module LM may include a light emitting diode. The light receiving module LRM may detect infrared rays. The light receiving module LRM may be activated in case that an infrared ray of a predetermined level or higher is detected. The light receiving module LRM may include a sensor such as a CMOS sensor. After the infrared light generated by the light emitting module LM is outputted, the infrared light may be reflected by an external object (e.g., a user's finger or face), and the reflected infrared light may be incident on the light receiving module LRM.

In this embodiment, the protective member SP-1 may include a first module hole MH1 and a second module hole MH2. The first module hole MH1 may overlap the first module 410, and the second module hole MH2 may overlap the second module 420. The first module hole MH1 and the second module hole MH2 may be defined by the side surfaces SP-S of the protective member SP-1 exposed through the upper and lower surfaces of the protective member SP-1.

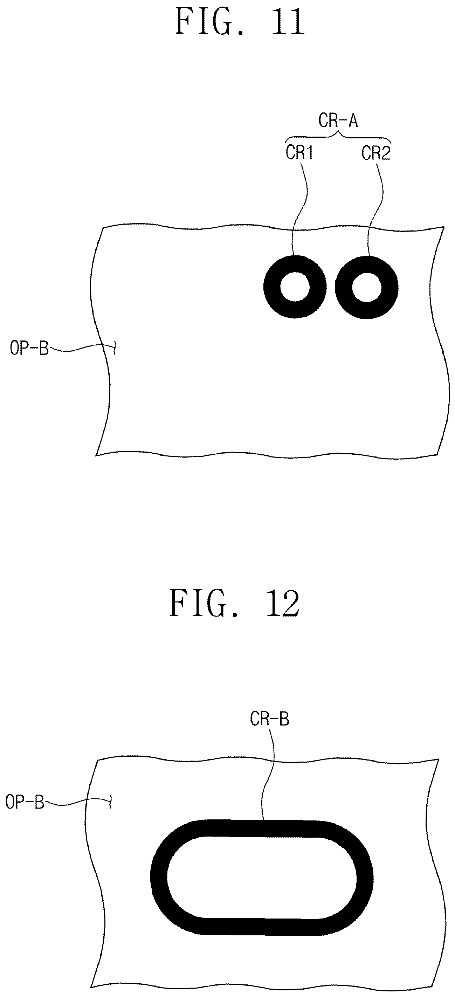

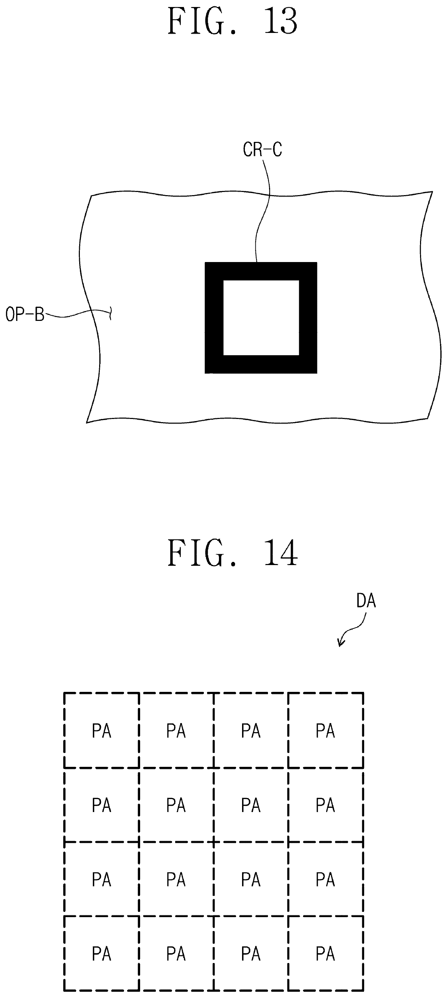

FIG. 11 is a schematic plan view of a cover pattern and a lower film according to an embodiment. FIG. 12 is a schematic plan view of a cover pattern and a lower film according to an embodiment. FIG. 13 is a schematic plan view of a cover pattern and a lower film according to an embodiment.

Referring to FIG. 11, in this embodiment, cover patterns CR-A disposed on the lower surface OP-B of the lower film OP may be provided. The cover pattern CR-A may include a first cover pattern CR1 and a second cover pattern CR2 spaced apart from each other.

The first cover pattern CR1 and the second cover pattern CR2 are illustrated in a circular shape but are not limited thereto. Each of the first cover pattern CR1 and the second cover pattern CR2 may have any one shape of an oval and a polygon and/or may have different shapes.

Referring to FIG. 12, in this embodiment, a cover pattern CR-B disposed on a lower surface OP-B of a lower film OP may have an elliptical shape. In this embodiment, multiple electronic modules 400 may be provided, and the cover pattern CR-B may surround all of the electronic modules 400.

Referring to FIG. 13, in this embodiment, the cover pattern CR-C disposed on the lower surface OP-B of the lower film OP may be a polygon. In FIG. 13, a square cover pattern CR-C is shown as an example of a polygon, but if the cover pattern CR-C has a polygonal shape, it is not limited to any one shape.

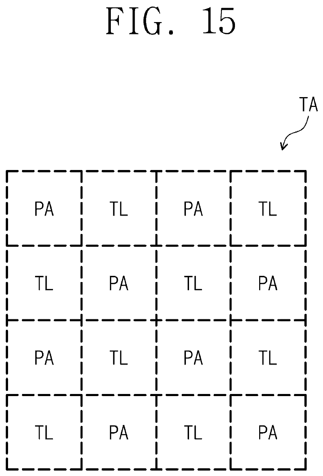

FIG. 14 is a schematic plan view of a display area according to an embodiment. FIG. 15 is a schematic plan view of a transmission area according to an embodiment.

Referring to FIGS. 14 and 15, according to the disclosure, only the light emitting pixels PA may be disposed in the display area DA, and the light emitting pixels PA and the non-light emitting pixels TL may be mixed and disposed in the transmission area TA.

Each of the light emitting pixels PA may have substantially the configuration identical to the pixel PX described in FIGS. 4A and 4B. For example, each of the light emitting pixels PA may include a light emitting element EE and a pixel circuit CC.

The non-light emitting pixels TL may be defined by omitting any one of elements included in the light emitting element EE and the pixel circuit CC. For example, in relation to the non-light emitting pixels TL, one of the electrodes included in the light emitting element EE in the configuration of the pixel PX may be omitted, or any one of the transistors T1 to T7 may be omitted. Accordingly, the non-light emitting pixels TL may be defined as a configuration in which light is not substantially generated. As the components of the light emitting pixels PA that reflect light are omitted, the non-light emitting pixels TL may have relatively high light transmittance compared to the light emitting pixels PA. Accordingly, the transmission area TA overlapping the electronic module 400 may easily transmit light.

In the transmission area TA, the light emitting pixels PA and the non-light emitting pixels TL may be alternately disposed. The non-light emitting pixels TL may be shifted in a diagonal direction in another row.

The arrangement of the light emitting pixels PA and the non-light emitting pixels TL is not limited thereto, and at least some of the non-light emitting pixels TL may have a structure surrounded by the light emitting pixels PA.

According to the disclosure, as the non-light emitting pixels TL are included in the transmission area TA of the display panel 210 overlapping the electronic module 400, transmittance of light incident to the transmission area TA or externally provided through the transmission area TA may be improved. Accordingly, it is possible to provide the electronic module 400 with improved reliability.

According to the disclosure, the cover pattern is disposed between the protective member and the lower film in which the module hole is defined. Separate holes for inserting the electronic module are not formed in the components disposed on the protective member. In particular, as a physical hole is not formed in the display module, damage applied to the display module may be reduced or minimized. Thus, an electronic device with improved reliability may be provided.

Although some embodiments of the disclosure have been described, it is understood that the disclosure should not be limited to these embodiments but various changes and modifications can be made by one ordinary skilled in the art within the scope of the claims.

## Claims

1. An electronic device (EA) comprising:
a display module (200) including a display area (DA) and a transmission area (TA) having a higher light transmittance than the display area (DA);
a lower film (OP) disposed under the display module (200) and including a transparent material;
a protective member (SP) disposed under the lower film (OP), the protective member (SP) including a module hole (MH) overlapping the transmission area (TA) and penetrating the protective member (SP);
an adhesive layer (AM5) disposed between the lower film (OP) and the protective member (SP) to attach the lower film (OP) and the protective member (SP);
at least one cover pattern (CR) disposed between the lower film (OP) and the protective member (SP); and
an electronic module (400) overlapping the module hole (MH),
wherein the at least one cover pattern (CR) has a closed line shape surrounding the module hole (MH), and the adhesive layer (AM5) is in contact with at least a portion of the at least one cover pattern (CR).

2. The electronic device (EA) of claim 1, wherein
the lower film (OP) comprises an upper surface adjacent to the display module (200) and a lower surface (OP-B) opposite to the upper surface, and
the at least one cover pattern (CR) is disposed on the lower surface (OP-B) of the lower film (OP).

3. The electronic device (EA) of claim 1 or 2, wherein
the at least one cover pattern (CR) overlaps the electronic module (400), the at least one cover pattern (CR) including a penetration opening part (CR-OP) exposing the lower surface (OP-B) of the lower film (OP), and
a width of the penetration opening part (CR-OP) in a direction is smaller than a width of the module hole (MH) in the direction.

4. The electronic device (EA) of claim 1 or 2, wherein
the at least one cover pattern (CR) overlaps the electronic module (400), the at least one cover pattern (CR) including a penetration opening part (CR-OP) exposing the lower surface (OP-B) of the lower film (OP), and
a width of the penetration opening part (CR-OP) in a direction is equal to a width of the module hole (MH) in the direction.

5. The electronic device (EA) of claim 1, wherein
the protective member (SP) comprises an upper surface (SP-U) adjacent to the lower film (OP) and a lower surface facing the upper surface (SP-U), and
the at least one cover pattern (CR) is disposed on the upper surface (SP-U) of the protective member (SP).

6. The electronic device (EA) of claim 5, wherein
the at least one cover pattern (CR) includes a penetration opening part (CR-OP) overlapping the electronic module (400), and
an inner side of the at least one cover pattern (CR) defining the penetration opening part (CR-OP) is aligned with an inner side of the protective member (SP) defining the module hole (MH).

7. The electronic device (EA) of claim 5, wherein the at least one cover pattern (CR) comprises:
a first pattern (CR-U) disposed on the upper surface (SP-U) of the protective member (SP); and
a second pattern (CR-S) disposed on an inner side of a protective member (SP) defining the module hole (MH).

8. The electronic device (EA) of at least one of claims 1 to 7, wherein the adhesive layer (AM5) overlaps at least a portion of the at least one cover pattern (CR).

9. The electronic device (EA) of claim 8, wherein the adhesive layer (AM5) overlaps the electronic module (400), the adhesive layer (AM5) including an adhesive opening part (AM-OP) exposing a portion of a lower surface (OP-B) of the lower film (OP).

10. The electronic device (EA) of at least one of claims 1 to 9, comprising a plurality of cover patterns (CR).

11. The electronic device (EA) of at least one of claims 1 to 10, wherein the at least one cover pattern (CR) is in shape of a circle, an oval, or a polygon.

12. The electronic device (EA) of at least one of claims 1 to 11, wherein the lower film (OP) is transparent.

13. The electronic device (EA) of at least one of claims 1 to 12, wherein the protective member (SP) comprises at least one of a light shielding layer, a heat dissipating layer, and a cushion layer.

14. The electronic device (EA) of at least one of claims 1 to 13, wherein the electronic device (EA) is foldable with respect to a folding axis (AX1) extending in a direction.

15. The electronic device (EA) of at least one of claims 1 to 14, wherein
the display module (200) comprises:
a light emitting pixel (PXPA) including at least one transistor (T1-T7), and a light emitting element (EE) electrically connected to the at least one transistor (T1-T7); and
a non-light emitting pixel (TL) free of at least one of the at least one transistor (T1-T7) and the light emitting element (EE),
the non-light emitting pixel (TL) is disposed only outside of the display area (DA), and
the light emitting pixel (PXPA) and the non-light emitting pixel (TL) are mixed and disposed in the transmission area (TA).

## Patentansprüche

1. Eine elektronische Vorrichtung (EA), umfassend:
ein Anzeigemodul (200) mit einem Anzeigebereich (DA) und einem Übertragungsbereich (TA), der eine höhere Lichtdurchlässigkeit als der Anzeigebereich (DA) aufweist;
einen unteren Film (OP), der unter dem Anzeigemodul (200) angeordnet ist und ein transparentes Material umfasst;
ein Schutzbauteil (SP), das unter dem unteren Film (OP) angeordnet ist, wobei das Schutzbauteil (SP) eine Modulöffnung (MH) umfasst, die sich mit dem Übertragungsbereich (TA) überlappt und das Schutzbauteil (SP) durchdringt;
eine Klebeschicht (AM5), die zwischen dem unteren Film (OP) und dem Schutzbauteil (SP) angeordnet ist, um den unteren Film (OP) und das Schutzbauteil (SP) miteinander zu verbinden;
mindestens ein Abdeckmuster (CR), das zwischen dem unteren Film (OP) und dem Schutzbauteil (SP) angeordnet ist; und
ein elektronisches Modul (400), das die Modulöffnung (MH) überlappt,
wobei das mindestens eine Abdeckmuster (CR) eine geschlossene Linienform aufweist, die die Modulöffnung (MH) umgibt, und die Klebeschicht (AM5) mit zumindest einem Teil des mindestens einen Abdeckmusters (CR) in Kontakt steht.

2. Die elektronische Vorrichtung (EA) nach Anspruch 1, wobei
der untere Film (OP) eine zum Anzeigemodul (200) benachbarte obere Oberfläche und eine der oberen Oberfläche gegenüberliegende untere Oberfläche (OP-B) umfasst, und
das mindestens eine Abdeckmuster (CR) auf der unteren Oberfläche (OP-B) des unteren Films (OP) angeordnet ist.

3. Die elektronische Vorrichtung (EA) nach Anspruch 1 oder 2, wobei
das mindestens eine Abdeckmuster (CR) das elektronische Modul (400) überlappt, wobei das mindestens eine Abdeckmuster (CR) einen Durchdringungsöffnungsbereich (CR-OP) umfasst, der die untere Oberfläche (OP-B) des unteren Films (OP) freilegt, und
eine Breite des Durchdringungsöffnungsbereichs (CR-OP) in einer Richtung kleiner als eine Breite der Modulöffnung (MH) in dieser Richtung ist.

4. Die elektronische Vorrichtung (EA) nach Anspruch 1 oder 2, wobei
das mindestens eine Abdeckmuster (CR) das elektronische Modul (400) überlappt, wobei das mindestens eine Abdeckmuster (CR) einen Durchdringungsöffnungsbereich (CR-OP) umfasst, der die untere Oberfläche (OP-B) des unteren Films (OP) freilegt, und
eine Breite des Durchdringungsöffnungsbereichs (CR-OP) in einer Richtung gleich einer Breite der Modulöffnung (MH) in dieser Richtung ist.

5. Die elektronische Vorrichtung (EA) nach Anspruch 1, wobei
das Schutzbauteil (SP) eine zum unteren Film (OP) benachbarte obere Oberfläche (SP-U) und eine der oberen Oberfläche (SP-U) gegenüberliegende untere Oberfläche umfasst, und
das mindestens eine Abdeckmuster (CR) auf der oberen Oberfläche (SP-U) des Schutzbauteils (SP) angeordnet ist.

6. Die elektronische Vorrichtung (EA) nach Anspruch 5, wobei
das mindestens eine Abdeckmuster (CR) einen Durchdringungsöffnungsbereich (CR-OP) umfasst, der das elektronische Modul (400) überlappt, und
eine innere Seite des mindestens einen Abdeckmusters (CR), die den Durchdringungsöffnungsbereich (CR-OP) definiert, mit einer inneren Seite des Schutzbauteils (SP), welche die Modulöffnung (MH) definiert, fluchtet.

7. Die elektronische Vorrichtung (EA) nach Anspruch 5, wobei das mindestens eine Abdeckmuster (CR) umfasst:
ein erstes Muster (CR-U), das auf der oberen Oberfläche (SP-U) des Schutzbauteils (SP) angeordnet ist; und
ein zweites Muster (CR-S), das auf einer inneren Seite des Schutzbauteils (SP) angeordnet ist, welche die Modulöffnung (MH) definiert.

8. Die elektronische Vorrichtung (EA) nach mindestens einem der Ansprüche 1 bis 7, wobei die Klebeschicht (AM5) sich mit zumindest einem Teil des mindestens einen Abdeckmusters (CR) überlappt.

9. Die elektronische Vorrichtung (EA) nach Anspruch 8, wobei die Klebeschicht (AM5) das elektronische Modul (400) überlappt, die Klebeschicht (AM5) einen Klebeöffnungsbereich (AM-OP) umfasst, der einen Teil der unteren Oberfläche (OP-B) des unteren Films (OP) freilegt.

10. Die elektronische Vorrichtung (EA) nach mindestens einem der Ansprüche 1 bis 9, umfassend eine Mehrzahl von Abdeckmustern (CR).

11. Die elektronische Vorrichtung (EA) nach mindestens einem der Ansprüche 1 bis 10, wobei das mindestens eine Abdeckmuster (CR) die Form eines Kreises, eines Ovals oder eines Polygons aufweist.

12. Die elektronische Vorrichtung (EA) nach mindestens einem der Ansprüche 1 bis 11, wobei der untere Film (OP) transparent ist.

13. Die elektronische Vorrichtung (EA) nach mindestens einem der Ansprüche 1 bis 12, wobei das Schutzbauteil (SP) mindestens eines aus einer lichtabschirmenden Schicht, einer wärmeableitenden Schicht und einer Polsterschicht umfasst.

14. Die elektronische Vorrichtung (EA) nach mindestens einem der Ansprüche 1 bis 13, wobei die elektronische Vorrichtung (EA) bezüglich einer Faltachse (AX1) faltbar ist, die sich in einer Richtung erstreckt.

15. Die elektronische Vorrichtung (EA) nach mindestens einem der Ansprüche 1 bis 14, wobei
das Anzeigemodul (200) umfasst:
ein lichtemittierendes Pixel (PXPA), das mindestens einen Transistor (T1-T7) umfasst, und ein Leuchtelement (EE), das elektrisch mit dem mindestens einen Transistor (T1-T7) verbunden ist; und
ein nicht lichtemittierendes Pixel (TL), das frei von mindestens einem des mindestens einen Transistors (T1-T7) und dem Leuchtelement (EE) ist,
wobei das nicht lichtemittierende Pixel (TL) ausschließlich außerhalb des Anzeigebereichs (DA) angeordnet ist, und
wobei das lichtemittierende Pixel (PXPA) und das nicht lichtemittierende Pixel (TL) im Übertragungsbereich (TA) gemischt angeordnet sind.

## Revendications

1. Dispositif électronique (EA) comprenant :
un module d'affichage (200) comportant une zone d'affichage (DA) et une zone de transmission (TA) présentant une transmittance lumineuse supérieure à la zone d'affichage (DA) ;
un film inférieur (OP) disposé sous le module d'affichage (200) et comportant un matériau transparent ;
un organe protecteur (SP) disposé sous le film inférieur (OP), l'organe protecteur (SP) comportant un trou de module (MH) chevauchant la zone de transmission (TA) et pénétrant l'organe protecteur (SP) ;
une couche adhésive (AM5) disposée entre le film inférieur (OP) et l'organe protecteur (SP) pour fixer le film inférieur (OP) et l'organe protecteur (SP) ;
au moins un motif de couverture (CR) disposé entre le film inférieur (OP) et l'organe protecteur (SP) ; et
un module électronique (400) chevauchant le trou de module (MH),
dans lequel l'au moins un motif de couverture (CR) présente une forme de ligne fermée entourant le trou de module (MH), et la couche adhésive (AM5) est en contact avec au moins une partie de l'au moins un motif de couverture (CR).

2. Dispositif électronique (EA) selon la revendication 1, dans lequel
le film inférieur (OP) comprend une surface supérieure adjacente au module d'affichage (200) et une surface inférieure (OP-B) opposée à la surface supérieure, et
l'au moins un motif de couverture (CR) est disposé sur la surface inférieure (OP-B) du film inférieur (OP).

3. Dispositif électronique (EA) selon la revendication 1 ou 2, dans lequel
l'au moins un motif de couverture (CR) chevauche le module électronique (400), l'au moins un motif de couverture (CR) comportant une partie d'ouverture de pénétration (CR-OP) exposant la surface inférieure (OP-B) du film inférieur (OP), et
une largeur de la partie d'ouverture de pénétration (CR-OP) dans une direction est plus petite qu'une largeur du trou de module (MH) dans la direction.

4. Dispositif électronique (EA) selon la revendication 1 ou 2, dans lequel
l'au moins un motif de couverture (CR) chevauche le module électronique (400), l'au moins un motif de couverture (CR) comportant une partie d'ouverture de pénétration (CR-OP) exposant la surface inférieure (OP-B) du film inférieur (OP), et
une largeur de la partie d'ouverture de pénétration (CR-OP) dans une direction est égale à une largeur du trou de module (MH) dans la direction.

5. Dispositif électronique (EA) selon la revendication 1, dans lequel
l'organe protecteur (SP) comprend une surface supérieure (SP-U) adjacente au film inférieur (OP) et une surface inférieure faisant face à la surface supérieure (SP-U), et
l'au moins un motif de couverture (CR) est disposé sur la surface supérieure (SP-U) de l'organe protecteur (SP).

6. Dispositif électronique (EA) selon la revendication 5, dans lequel
l'au moins un motif de couverture (CR) comporte une partie d'ouverture de pénétration (CR-OP) chevauchant le module électronique (400), et
un côté interne de l'au moins un motif de couverture (CR) définissant la partie d'ouverture de pénétration (CR-OP) est aligné avec un côté interne de l'organe protecteur (SP) définissant le trou de module (MH).

7. Dispositif électronique (EA) selon la revendication 5, dans lequel l'au moins un motif de couverture (CR) comprend :
un premier motif (CR-U) disposé sur la surface supérieure (SP-U) de l'organe protecteur (SP) ; et
un deuxième motif (CR-S) disposé sur un côté interne d'un organe protecteur (SP) définissant le trou de module (MH).

8. Dispositif électronique (EA) selon au moins l'une des revendications 1 à 7, dans lequel la couche adhésive (AM5) chevauche au moins une partie de l'au moins un motif de couverture (CR).

9. Dispositif électronique (EA) selon la revendication 8, dans lequel la couche adhésive (AM5) chevauche le module électronique (400), la couche adhésive (AM5) comportant une partie d'ouverture adhésive (AM-OP) exposant une partie d'une surface inférieure (OP-B) du film inférieur (OP).

10. Dispositif électronique (EA) selon au moins l'une des revendications 1 à 9, comprenant une pluralité de motifs de couverture (CR).

11. Dispositif électronique (EA) selon au moins l'une des revendications 1 à 10, dans lequel l'au moins un motif de couverture (CR) présente la forme d'un cercle, d'un ovale ou d'un polygone.

12. Dispositif électronique (EA) selon au moins l'une des revendications 1 à 11, dans lequel le film inférieur (OP) est transparent.

13. Dispositif électronique (EA) selon au moins l'une des revendications 1 à 12, dans lequel l'organe protecteur (SP) comprend au moins l'une parmi une couche écran à la lumière, une couche de dissipation de chaleur et une couche d'amortissement.

14. Dispositif électronique (EA) selon au moins l'une des revendications 1 à 13, dans lequel le dispositif électronique (EA) est pliable par rapport à un axe de pliage (AX1) s'étendant dans une direction.

15. Dispositif électronique (EA) selon au moins l'une des revendications 1 à 14, dans lequel le module d'affichage (200) comprend :
un pixel électroluminescent (PXPA) comportant au moins un transistor (T1-T7), et un élément électroluminescent (EE) connecté électriquement à l'au moins un transistor (T1-T7) ; et
un pixel non-électroluminescent (TL) dépourvu d'au moins l'un parmi l'au moins un transistor (T1-T7) et l'élément électroluminescent (EE),
le pixel non-électroluminescent (TL) est disposé seulement à l'extérieur de la zone d'affichage (DA), et
le pixel électroluminescent (PXPA) et le pixel non-électroluminescent (TL) sont mélangés et disposés dans la zone de transmission (TA).
